# EUROPEAN PATENT APPLICATION

(11) **EP 4 845 330 A1**
(43) Date of publication of application: **25.11.2026**
(21) Application number: 26166033.6
(22) Date of filing: 19.03.2026
(51) Int. Cl.: H10B 12/00, H10W 10/17, H10W 10/20

(54) **SEMICONDUCTOR DEVICE INCLUDING DEVICE ISOLATION STRUCTURE**

(30) Priority: 23.05.2025 KR 20250067430
(71) Applicant: Samsung Electronics Co., Ltd., Suwon-si, Gyeonggi-do 16677 (KR)
(72) Inventor: PARK, Hyojin, 16677 Suwon-si, Gyeonggi-do (KR)
(74) Representative: Kuhnen & Wacker Patent- und Rechtsanwaltsbüro PartG mbB

(57) **Abstract**

A semiconductor device (100) includes a substrate (101) having a cell array region (CAR), a plurality of trenches defining a cell active region (ACT) on the cell array region (CAR), and including a first trench and a second trench, a first cell device isolation structure within the first trench, a second cell device isolation structure within the second trench, the second cell device isolation structure being spaced apart from the first cell device isolation structure in a first direction (X). The first cell device isolation structure (110C1) includes a first insulating layer (115) on a sidewall and a bottom surface of the first trench, a second insulating layer (116) on the first insulating layer (115), and a third insulating layer (117) filling at least a portion of an upper region of the second insulating layer (116). The second cell device isolation structure (110C2) includes a buried insulating layer (118) filling the second trench.

## Description

### TECHNICAL FIELD

The present disclosure relates to a semiconductor device and a method of manufacturing the same.

### BACKGROUND

As the electronics industry develops and user demand increases, electronic devices are becoming smaller and more powerful. Accordingly, semiconductor devices used in electronic devices are also desired to be highly integrated and more powerful. To manufacture highly scaled semiconductor devices, technologies are demanded to reduce an environmental difference between areas.

### SUMMARY

Example implementations provide a semiconductor device having improved reliability and improved performance. The invention is set out in the appended claims.

According to example implementations, a semiconductor device includes a substrate having a cell array region; a plurality of trenches defining a cell active region on the cell array region, and including a first trench and a second trench; a first cell device isolation structure within the first trench; a second cell device isolation structure within the second trench, the second cell device isolation structure being spaced apart from the first cell device isolation structure in a first direction; and a gate structure including a gate electrode crossing the cell active region in the first direction, on the cell array region. The first cell device isolation structure includes a first insulating layer on a sidewall and a bottom surface of the first trench; a second insulating layer on the first insulating layer; and a third insulating layer filling at least a portion of an upper region of the second insulating layer (exemplarily, the third insulating layer is arranged on the second insulating layer and in at least a portion of an upper region of the first trench). The second cell device isolation structure includes a filling insulating layer (or buried insulating layer) filling the second trench, and a lower surface of the third insulating layer of the first cell device isolation structure is at a higher level than a lower surface of the filling insulating layer of the second cell device isolation structure.

According to example implementations, a semiconductor device includes a substrate having a cell array region; a trench defining a cell active region on the cell array region; a cell device isolation structure within the trench; and a gate structure including a gate electrode crossing the cell active region in a first direction, on the cell array region. The cell device isolation structure includes a first insulating liner on a sidewall and a bottom surface of the trench; a second insulating liner on the first insulating liner; and a filling insulating layer disposed on the second insulating liner and filling the trench. An upper surface of the first insulating liner, an upper surface of the second insulating liner, and an upper surface of the filling insulating layer are substantially coplanar.

According to example implementations, a semiconductor device includes a substrate having a cell array region; a trench defining a cell active region on the cell array region; a cell device isolation structure within the trench; and a gate structure including a gate electrode crossing the cell active region in a first direction, on the cell array region. The cell active region includes a body portion on the substrate; and a saddle portion protruding from the body portion toward the gate structure, and the cell device isolation structure includes a first insulating liner on a sidewall of the body portion defined by the trench and a bottom surface of the trench; a second insulating liner on the first insulating liner; and a filling insulating layer filled in an upper region of the second insulating liner. The second insulating liner and the filling insulating layer are spaced apart from the body portion of the cell active region.

### BRIEF DESCRIPTION OF DRAWINGS

The above and other aspects, features, and advantages of the present inventive concept will be more clearly understood from the following detailed description, taken in conjunction with the accompanying drawings, in which:
FIG. 1 is a plan view illustrating a semiconductor device according to some implementations;
FIGS. 2A, 2B, and 2C are schematic cross-sectional views illustrating a semiconductor device according to some implementations;
FIG. 3 is a schematic partially-enlarged view illustrating a semiconductor device according to some implementations;
FIG. 4 is a schematic partially-enlarged view illustrating a semiconductor device according to some implementations;
FIG. 5 is a schematic partially-enlarged view illustrating a semiconductor device according to some implementations;
FIG. 6 is a schematic partially-enlarged view illustrating a semiconductor device according to some implementations;
FIG. 7 is a schematic partially-enlarged view illustrating a semiconductor device according to some implementations;
FIG. 8 is a schematic partially-enlarged view illustrating a semiconductor device according to some implementations;
FIG. 9 is a schematic partially-enlarged view illustrating a semiconductor device according to some implementations;
FIG. 10 is a schematic partially-enlarged view illustrating a semiconductor device according to some implementations;
FIGS. 11A, 11B, 12A, 12B, 13A, 13B, 14A, 14B, 15A, 15B, 16A, 16B, 17A, and 17B are cross-sectional views illustrating a process sequence of a method of manufacturing a semiconductor device according to some implementations; and
FIGS. 18A and 18B are cross-sectional views illustrating a process sequence of a method of manufacturing a semiconductor device according to some implementations.

### DETAILED DESCRIPTION

Hereinafter, terms such as 'on', 'upper portion', 'upper surface', 'below', 'lower portion', 'side surface', 'top', 'bottom', and the like are understood to refer to the drawings, except in cases where they are indicated separately by drawing symbols. Terms such as "upper," "middle," "intermediate," and "lower" may be replaced with other terms, such as "first," "second," "third," and the like, and used to describe components of the specification. Terms such as "first," "second," and "third" may be used to describe various components, but the components are not limited by the terms, and "first component" may be named "second component".

Hereinafter, example implementations are described with reference to the attached drawings.

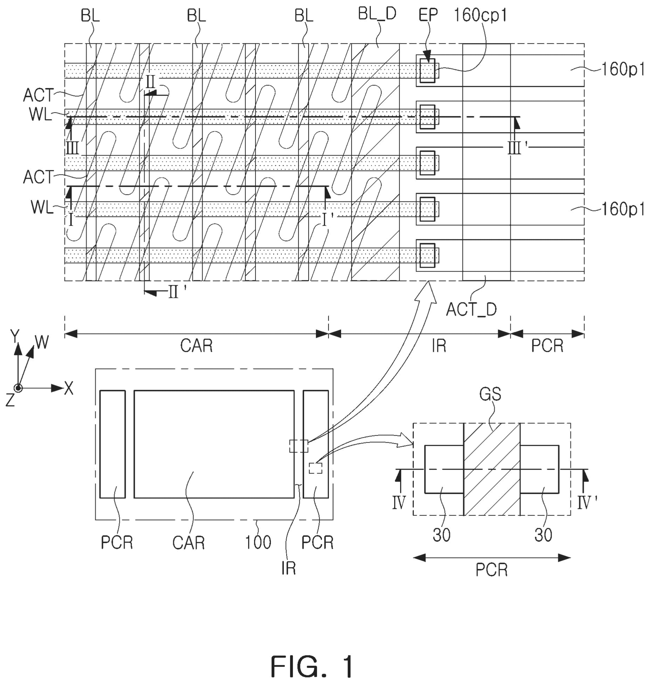

FIG. 1 is a plan view illustrating a semiconductor device according to example implementations.

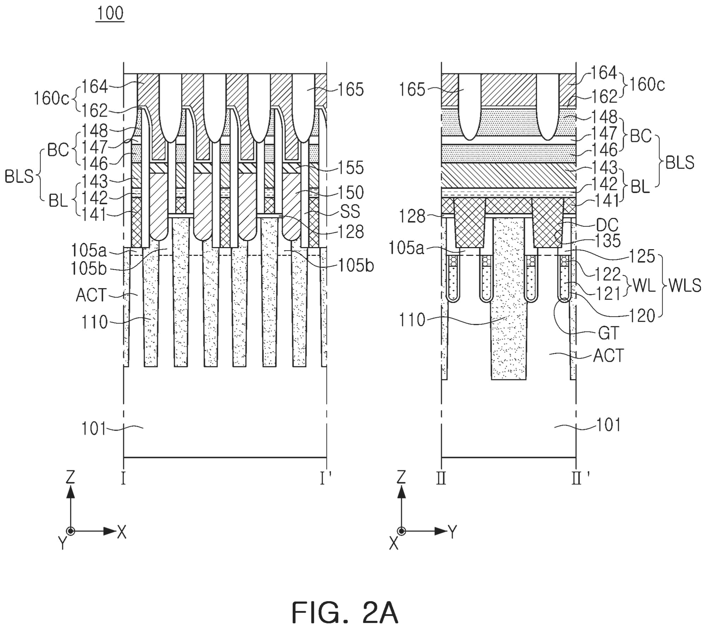

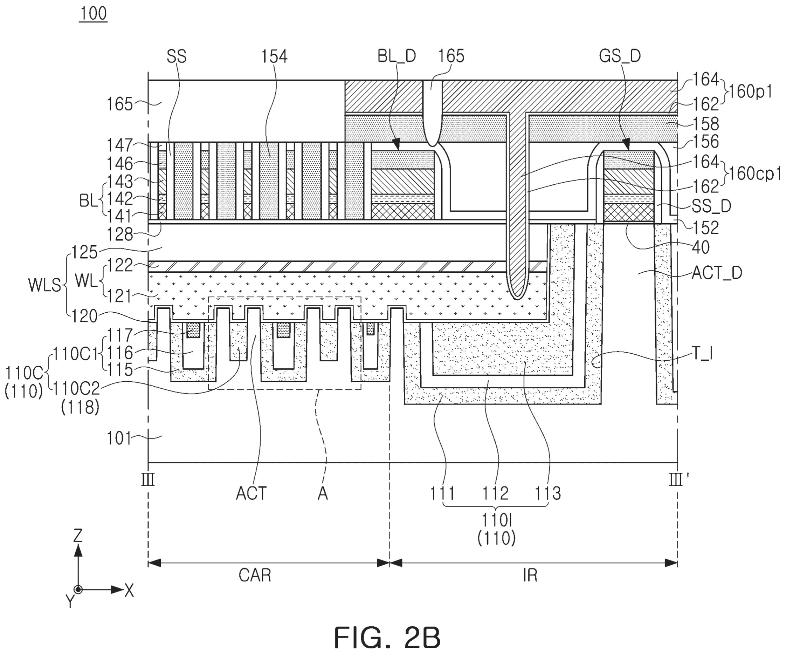

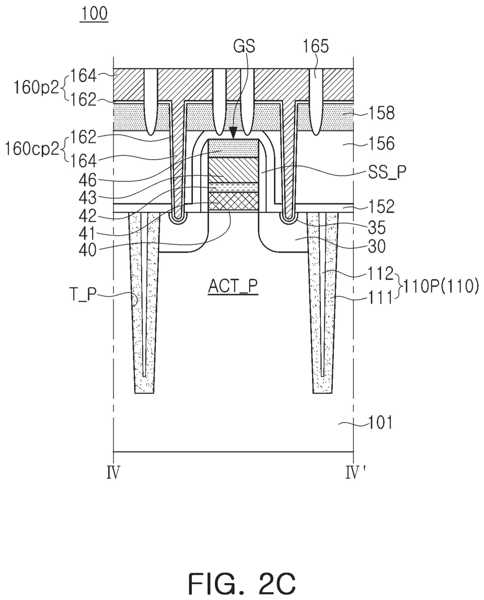

FIGS. 2A, 2B, and 2C are schematic cross-sectional views illustrating a semiconductor device according to some implementations. FIG. 2A illustrates a cross-section of the semiconductor device of FIG. 1 along cut lines I-I' and II-II'. FIG. 2B illustrates a cross-section of the semiconductor device of FIG. 1 along cut line III-III'. FIG. 2C illustrates a cross-section of the semiconductor device of FIG. 1 along cut line IV-IV'.

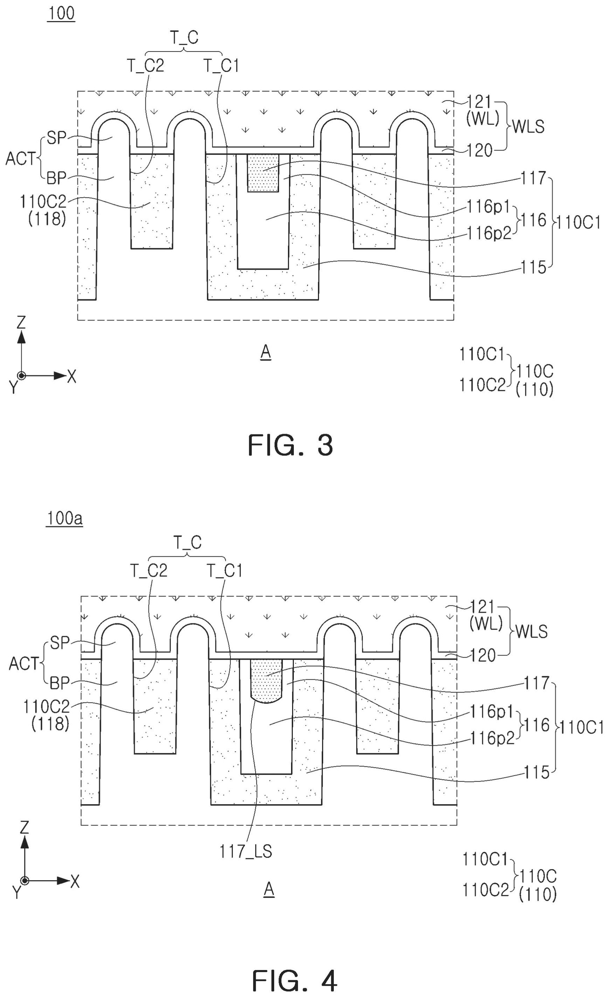

FIG. 3 is a schematic partially-enlarged view illustrating a semiconductor device according to some implementations. FIG. 3 is a partially-enlarged view of area 'A' of FIG. 2B.

Referring to FIGS. 1, 2A, 2B, 2C, and 3, a semiconductor device 100 may include a cell array region CAR, a peripheral circuit region PCR for driving the cell array region CAR, and a connection region IR between the cell array region CAR and the peripheral circuit region PCR. In this specification, the regions CAR, PCR, and IR may be defined and described in the substrate 101. The cell array region CAR may be a region where memory cells are disposed. The peripheral circuit region PCR may be disposed around the cell array region CAR. The peripheral circuit region PCR may be a region where word line drivers, sense amplifiers, row and column decoders, and control circuits are disposed. The connection region IR may be a region for electrically connecting the cell array region CAR to the peripheral circuit region PCR. For example, in the connection region IR, the word line WL may be connected to the contact plug 160cp1, and the contact plug 160cp1 may be connected to the second upper conductive pattern 160p1.

A semiconductor device 100 may include a substrate 101 including active regions ACT, an device isolation structure 110 defining the active regions ACT within the substrate 101, a word line structure WLS buried and extending within the substrate 101 and including a word line WL, a bit line structure BLS extending across the word line structure WLS on the substrate 101 and including a bit line BL, and a dummy bit line structure BL_D. The active regions ACT, the word line structure WLS, and the bit line structure BLS may be disposed in a cell array region CAR. The dummy bit line structure BL_D may be disposed in a connection region IR. The dummy bit line structure BL_D may be referred to as a dummy bit line.

The semiconductor device 100 may further include a lower conductive pattern 150 on an active region ACT, a first upper conductive pattern 160c on the lower conductive pattern 150, a contact plug 160cp1 connected to a word line WL in a connection region IR, a second upper conductive pattern 160p1 on the contact plug 160cp1, a peripheral contact plug 160cp2 connected to a peripheral source/drain region 30 in a peripheral circuit region PCR, a third upper conductive pattern 160p2 on the peripheral contact plug 160cp2, and an insulating pattern 165 penetrating the first upper conductive pattern 160c, the second upper conductive pattern 160p1 and the third upper conductive pattern 160p2.

The semiconductor device 100 may further include a peripheral transistor, an insulating liner 152, and interlayer insulating layers 156 and 158 disposed on the substrate 101 in the connection region IR and the peripheral circuit region PCR. The peripheral transistor may include a peripheral gate dielectric layer 40, peripheral circuit gate electrodes 41, 42, and 43, and a peripheral source/drain region 30.

The semiconductor device 100 may include, for example, a cell array of a Dynamic Random Access Memory (DRAM). For example, a bit line BL may be connected to a first impurity region 105a of an active region ACT, and a second impurity region 105b of the active region ACT may be electrically connected to a capacitor structure on the first upper conductive pattern 160c, through the lower conductive pattern 150 and the first upper conductive pattern 160c. In some implementations, the capacitor structure may include, for example, a lower electrode, a capacitor dielectric layer, and an upper electrode, and the structure thereof is not particularly limited.

The substrate 101 may include a semiconductor material, such as a group IV semiconductor, a group III-V compound semiconductor, or a group II-VI compound semiconductor. For example, the group IV semiconductor may include silicon, germanium, or silicon-germanium. The substrate 101 may further include impurities. The substrate 101 may be a silicon substrate, a silicon-on-insulator (SOI) substrate, a germanium substrate, a germanium-on-insulator (GOI) substrate, a silicon-germanium substrate, or a substrate including an epitaxial layer.

The active regions ACT may be defined within the substrate 101 by a device isolation structure 110. The active region ACT may be in the form of a bar and may be disposed in an island shape extending in one direction, for example, in the W direction, within the substrate 101. The W direction may be an inclined direction with respect to the extension direction of the word lines WL and the bit lines BL. The active regions ACT may be arranged to be parallel to each other, and an end of one active region ACT may be arranged to be adjacent to the center of another active region ACT adjacent thereto.

The active region ACT may include a body portion BP on the substrate 101 and a saddle portion SP protruding in a vertical direction (Z) from the body portion BP. The body portion BP may be surrounded by first and second cell device isolation structures 110C1 and 110C2. The saddle portion SP may protrude from the body portion BP toward the word line structure WLS and may be covered by a gate dielectric layer 120. The saddle portion SP may have a convex upper surface toward the vertical direction (Z).

The active region ACT may have first and second impurity regions 105a and 105b at a predetermined depth from the upper surface of the substrate 101. The first and second impurity regions 105a and 105b may be spaced apart from each other. The first and second impurity regions 105a and 105b may be provided as source/drain regions of a transistor configured by a word line WL. For example, a drain region may be formed between two word lines WL crossing one active region ACT, and a source region may be formed outside the two word lines WL. The source region and the drain region are formed by first and second impurity regions 105a and 105b by doping or ion implantation of substantially the same impurities, and may be referred to interchangeably depending on the circuit configuration of the transistor to be finally formed. The impurities may include dopants having a conductivity type opposite to that of the substrate 101. In example implementations, the depths of the first and second impurity regions 105a and 105b in the source region and the drain region may be different from each other.

The cell active region ACT on the cell array region CAR, the peripheral active region ACT_P on the peripheral circuit region PCR, and the dummy active region ACT_D on the connection region IR may be defined by a plurality of different trenches T.

The plurality of trenches T may include cell element isolation trenches T_C, peripheral element isolation trenches T_P, and connection element isolation trenches T_I.

The cell active region ACT may be defined in the cell element isolation trenches T_C. The cell element isolation trenches T_C may include first and second cell element isolation trenches T_C1 and T_C2. In some implementations, the first cell element isolation trench T_C1 may be referred to as a first trench, and the second cell element isolation trench T_C2 may be referred to as a second trench. The first and second cell element isolation trenches T_C1 and T_C2 may be formed alternately along one direction (see FIG. 2B and FIG. 3).

The peripheral active region ACT_P may be defined by the peripheral element isolation trenches T_P.

The dummy active region ACT_D may be defined by a connecting element isolation trench T_I.

The device isolation structure 110 may be formed by a shallow trench isolation (STI) process. The device isolation structure 110 may surround active regions ACT and electrically isolate the active regions ACT from each other. The device isolation structure 110 may be formed of an insulating material, for example, silicon oxide, silicon nitride, or a combination thereof. The device isolation structure 110 may include a plurality of regions having different bottom depths according to the width of a trench in which the substrate 101 is etched.

The device isolation structure 110 may include cell device isolation structures 110C defining a cell active region ACT on a cell array region CAR, a peripheral device isolation structure 110P defining a peripheral active region ACT_P on a peripheral circuit region PCR, and a connection device isolation structure 110I defining a dummy active region ACT_D on a connection region IR.

On the cell array region CAR, cell device isolation structures 110C may be formed within cell element isolation trenches T_C. The cell device isolation structures 110C may include, for example, a first cell device isolation structure 110C1 within a first trench T_C1 and a second cell device isolation structure 110C2 within a second trench T_C2.

The first cell device isolation structure 110C1 may include a plurality of layers. For example, the first cell device isolation structure 110C1 may include a first insulating layer 115, a second insulating layer 116, and a third insulating layer 117.

The first insulating layer 115 may be disposed on the sidewall and bottom surface of the first trench T_C1. In another aspect, the first insulating layer 115 may extend downward along one sidewall of the body portion BP of the cell active region ACT defined by the first trench T_C1 and may be disposed on the bottom surface of the first trench T_C1.

The second insulating layer 116 may be disposed on the first insulating layer 115. The third insulating layer 117 may fill at least a portion of the upper region of the second insulating layer 116. In other words, the third insulating layer 117 may be arranged on the second insulating layer 116 in a portion of the upper region of the first trench T_C1. The width of the third insulating layer 117 in the first direction (X) may become smaller toward the lower surface of the third insulating layer 117.

The second insulating layer 116 may surround the side surface and the lower surface of the third insulating layer 117. For example, the second insulating layer 116 may include a first portion 116p1 disposed between the inner side surface of the first insulating layer 115 and the side surface of the third insulating layer 117, and covering the side surface of the third insulating layer 117. The second insulating layer 116 may further include a second portion 116p2 disposed below the first portion 116p1 and covering the lower surface of the third insulating layer 117. The width of the second portion 116p2 in the first direction (X) may be larger than the width of the first portion 116p1 in the first direction (X). The first and second portions 116p1 and 116p2 are provided to describe the shape and arrangement of the second insulating layer 116, and the boundary between the first and second portions 116p1 and 116p2 may not be distinguished.

The second and third insulating layers 116 and 117 may be spaced apart from the cell active region ACT. For example, the second and third insulating layers 116 and 117 may be spaced apart from the sidewall of the body portion BP in the first direction (X).

The upper surface of the first cell device isolation structure 110C1 may be substantially coplanar. In another aspect, the respective upper surfaces of the first insulating layer 115, the second insulating layer 116, and the third insulating layer 117 may be substantially at the same level from the lower surface of the first trench T_C1.

In some implementations, the first insulating layer 115 may be referred to as a first insulating liner, the second insulating layer 116 may be referred to as a second insulating liner, and the third insulating layer 117 may be referred to as a buried insulating layer.

The second cell device isolation structure 110C2 may include a fourth insulating layer 118 within the second trench T_C2. The fourth insulating layer 118 may be disposed between two adjacent active regions ACT. In some implementations, the fourth insulating layer 118 may be referred to as a buried insulating layer that fills the second trench T_C2. The second cell device isolation structure 110C2 may include a single layer, but is not limited thereto.

The respective upper surfaces of the first cell device isolation structure 110C1 and the second cell device isolation structure 110C2 may be substantially at the same level from the lower surface of the substrate 101. In another aspect, the respective upper surfaces of the first cell device isolation structure 110C1 and the second cell device isolation structure 110C2 may be substantially coplanar.

The lower surfaces of the first cell device isolation structure 110C1 and the second cell device isolation structure 110C2 may be at different levels. The lower surface of the second cell device isolation structure 110C2 may be at a higher level than the lower surface of the first cell device isolation structure 110C1. In another aspect, the lower surface of the first insulating layer 115 of the first cell device isolation structure 110C1 may be at a lower level than the lower surface of the second cell device isolation structure 110C2.

The lower surface of the third insulating layer 117 of the first cell device isolation structure 110C1 may be at a higher level than the lower surface of the second cell device isolation structure 110C2.

The first insulating layer 115 and the fourth insulating layer 118 may include the same insulating material. For example, the first insulating layer 115 and the fourth insulating layer 118 may include silicon oxide.

The second insulating layer 116 and the third insulating layer 117 may include an insulating material different from the first insulating layer 115. The second and third insulating layers 116 and 117 may include, for example, a nitride-based silicon insulating film. The nitride-based silicon insulating film may include at least one of silicon nitride, silicon carbonitride, and silicon oxycarbonitride.

The second and third insulating layers 116 and 117 may include different nitride-based silicon insulating films. The second insulating layer 116 may include, for example, a first nitride-based silicon insulating film, and the third insulating layer 117 may include a second nitride-based silicon insulating film that is different from the first nitride-based silicon insulating film. In some implementations, the first nitride-based silicon insulating film may include silicon nitride, and the second nitride-based silicon insulating film may include silicon carbon nitride.

On the connection region IR, a connection device isolation structure 110I may be formed within a connection element isolation trench T_I. The connection device isolation structure 110I may include a plurality of layers. For example, the connection device isolation structure 110I may include a first insulating liner 111, a second insulating liner 112, and a buried insulating layer 113. The second insulating liner 112 may be disposed on the first insulating liner 111, and the buried insulating layer 113 may be disposed on the second insulating liner 112. The first insulating liner 111 and the second insulating liner 112 may be sequentially conformally formed along a surface of the connection element isolation trench T_I in an etched connection element isolation trench T_I of the substrate 101 in which the connection device isolation structure 110I is disposed. The buried insulating layer 113 may fill a space that the first and second insulating liners 111 and 112 do not fill in the connection element isolation trench T_I. The second insulating liner 112 may include an insulating material different from that of the first insulating liner 111, and the buried insulating layer 113 may include an insulating material different from that of the second insulating liner 112. For example, the first insulating liner 111 and the buried insulating layer 113 may include silicon oxide, and the second insulating liner 112 may include silicon nitride.

The word line structures WLS may be disposed within gate trenches 115 extending within the substrate 101. Each of the word line structures WLS may include a gate dielectric layer 120, a word line WL, and a gate capping layer 125. In this specification, 'gate (120, WL)' may be referred to as a structure including the gate dielectric layer 120 and the word line WL, the word line WL may be referred to as a 'gate electrode', and the word line structure WLS may be referred to as a 'gate structure'.

The word line WL may be disposed to extend in the first direction (X) across the active region ACT. For example, a pair of adjacent word lines WL may be disposed across an active region ACT. The word lines WL may form a gate of a buried channel array transistor (BCAT), but are not limited thereto. In example implementations, the word lines WL may also be disposed on the upper portion of the substrate 101. The word lines WL may be disposed at a predetermined thickness on the lower portion of the gate trench 115. The upper surface of the word lines WL may be located at a lower level than the upper surface of the substrate 101.

The word lines WL may include a conductive material, for example, at least one of polycrystalline silicon (Si), titanium (Ti), titanium nitride (TiN), tantalum (Ta), tantalum nitride (TaN), tungsten (W), tungsten nitride (WN), and aluminum (Al). For example, the word line WL may include a lower pattern 121 and an upper pattern 122 formed of different materials.

For example, the lower pattern 121 may include at least one of tungsten (W), titanium (Ti), tantalum (Ta), tungsten nitride (WN), titanium nitride (TiN), and tantalum nitride (TaN). For example, the upper pattern 122 may be a semiconductor pattern including polysilicon doped with P-type or N-type impurities, and the lower pattern 121 may be a metal pattern including at least one of a metal and a metal nitride. The thickness of the lower pattern 121 may be thicker than the thickness of the upper pattern 122. Each of the lower pattern 121 and the upper pattern 122 may extend in the first direction (X).

The gate dielectric layer 120 may be disposed on the bottom surface and inner side surfaces of the gate trench GT. The gate dielectric layer 120 may conformally cover an inner wall of the gate trench GT. The gate dielectric layer 120 may conformally cover an upper surface of the first cell device isolation structure 110C1. For example, the gate dielectric layer 120 may conformally cover the upper surfaces of the first insulating layer 115, the second insulating layer 116, and the third insulating layer 117. The gate dielectric layer 120 may be substantially coplanar on the first cell device isolation structure 110C1. On the first cell device isolation structure 110C1, the gate dielectric layer 120 may be at the same level as an upper surface of the second trench T_C2. The gate dielectric layer 120 may include at least one of silicon oxide, silicon nitride, and silicon oxynitride. The gate dielectric layer 120 may be, for example, a silicon oxide film or an insulating film having a high dielectric constant. In example implementations, the gate dielectric layer 120 may be a layer formed by oxidizing the active region ACT or a layer formed by deposition.

The gate capping layer 125 may be disposed to fill the gate trench GT on top of the word line WL. The upper surface of the gate capping layer 125 may be located at substantially the same level as the upper surface of the substrate 101. The gate capping layer 125 may be formed of an insulating material, for example, silicon nitride.

The bit line structure BLS may extend in one direction, for example, in the Y-direction, perpendicular to the word line WL. The bit line structure BLS may include a bit line BL and a bit line capping pattern BC on the bit line BL. The bit line structure BLS may be disposed on a cell array region CAR.

The dummy bit line structure BL_D may extend in a direction parallel to the direction in which the bit line structure BLS extends, for example, in the Y-direction. The dummy bit line structure BL_D may be disposed on a connection region IR. The dummy bit line structure BL_D may have a structure similar to the bit line structure BLS, except that it has a larger width in the X-direction than the bit line structure BLS.

The bit line BL may include a first conductive pattern 141, a second conductive pattern 142, and a third conductive pattern 143 that are sequentially stacked. The bit line capping pattern BC may be disposed on the third conductive pattern 143. A buffer insulating layer 128 may be disposed between the first conductive pattern 141 and the substrate 101, and a portion (hereinafter, referred to as a bit line contact pattern DC) of the first conductive pattern 141 may be in contact with a first impurity region 105a of an active region ACT. The bit line BL may be electrically connected to the first impurity region 105a through the bit line contact pattern DC. A lower surface of the bit line contact pattern DC may be located at a lower level than an upper surface of the substrate 101 and may be located at a higher level than an upper surface of the word line WL. In some implementations, the bit line contact pattern DC may be locally disposed within a bit line contact hole 135 formed in the substrate 101 and exposing the first impurity region 105a.

The first conductive pattern 141 may include a semiconductor material such as polycrystalline silicon. The first conductive pattern 141 may be in direct contact with the first impurity region 105a. The second conductive pattern 142 may include a metal-semiconductor compound. The metal-semiconductor compound may be, for example, a layer in which a portion of the first conductive pattern 141 is silicided. For example, the metal-semiconductor compound may include cobalt silicide (CoSi), titanium silicide (TiSi), nickel silicide (NiSi), tungsten silicide (WSi), or other metal silicides. The third conductive pattern 143 may include a metal material such as titanium (Ti), tantalum (Ta), tungsten (W), and aluminum (Al). The number of conductive patterns forming the bit line BL, the type of material, and/or the stacking order may vary depending on example implementations.

The bit line capping pattern BC may include a first capping pattern 146, a second capping pattern 147, and a third capping pattern 148 sequentially stacked on a third conductive pattern 143. The first to third capping patterns 146, 147, and 148 may each include an insulating material, for example, a silicon nitride film. The first to third capping patterns 146, 147, and 148 may be formed of different materials, and even if they include the same material, a boundary may be distinguished due to a difference in physical properties. The thickness of the second capping pattern 147 may be smaller than the thickness of the first capping pattern 146 and the thickness of the third capping pattern 148, respectively. The number and/or the type of material of the capping patterns forming the bit line capping pattern BC may vary depending on implementations.

The spacer structures SS may be disposed on both sidewalls of each of the bit line structures BLS and may extend in one direction, for example, the Y-direction. The spacer structures SS may be disposed between the bit line structure BLS and the lower conductive pattern 150. The spacer structures SS may be disposed to extend along the sidewalls of the bit line BL and the sidewalls of the bit line capping pattern BC. A pair of spacer structures SS disposed on both sides of one bit line structure BLS may have an asymmetrical shape with respect to the bit line structure BLS. Each of the spacer structures SS may include a plurality of spacer layers and may further include an air spacer according to example implementations. The semiconductor device 100 may further include fence insulating patterns 154 between the spacer structures SS. The fence insulating patterns 154 may include silicon nitride or silicon oxynitride.

The semiconductor device 100 may further include dummy spacer structures SS_D disposed on one side of the dummy bit line structure BL_D and the side surface of the dummy gate structure GS_D. Each of the dummy spacer structures SS_D may include a plurality of spacer layers, and may further include an air spacer according to example implementations.

The lower conductive pattern 150 may be connected to one area of the active region ACT, for example, the second impurity region 105b. The lower conductive pattern 150 may be disposed between the bit lines BL and between the word lines WL. The lower conductive pattern 150 may penetrate the buffer insulating layer 128 and be connected to the second impurity region 105b of the active region ACT. The lower conductive pattern 150 may be in direct contact with the second impurity region 105b. The lower surface of the lower conductive pattern 150 may be located at a level lower than the upper surface of the substrate 101 and may be located at a level higher than the lower surface of the bit line contact pattern DC. The lower conductive pattern 150 may be insulated from the bit line contact pattern DC by the spacer structure SS. The lower conductive pattern 150 may be formed of a conductive material, and may include at least one of, for example, polycrystalline silicon (Si), titanium (Ti), titanium nitride (TiN), tantalum (Ta), tantalum nitride (TaN), tungsten (W), tungsten nitride (WN), and aluminum (Al). In some implementations, the lower conductive pattern 150 may include a plurality of layers.

A metal-semiconductor compound layer 155 may be disposed between the lower conductive pattern 150 and the first upper conductive pattern 160c. The metal-semiconductor compound layer 155 may be, for example, a layer that silicides a portion of the lower conductive pattern 150 when the lower conductive pattern 150 includes a semiconductor material. The metal-semiconductor compound layer 155 may include, for example, cobalt silicide (CoSi), titanium silicide (TiSi), nickel silicide (NiSi), tungsten silicide (WSi), or other metal silicides. According to example implementations, the metal-semiconductor compound layer 155 may be omitted.

The first upper conductive pattern 160c may be disposed on the lower conductive pattern 150 in the cell array region CAR. The first upper conductive pattern 160c may extend between the spacer structures SS to cover the upper surface of the metal-semiconductor compound layer 155. The second and third upper conductive patterns 160p1 and 160p2 may be disposed on the connection region IR and the peripheral circuit region PCR. The respective upper surfaces of the first to third upper conductive patterns 160c, 160p1, and 160p2 may be disposed at substantially the same level. The first upper conductive pattern 160c, the second upper conductive pattern 160p1, and the third upper conductive pattern160p2 may each include a barrier layer 162 and a conductive layer 164. The barrier layer 162 may cover the lower surface and side surfaces of the conductive layer 164. The barrier layer 162 may include a metal nitride, for example, at least one of titanium nitride (TiN), tantalum nitride (TaN), and tungsten nitride (WN). The conductive layer 164 may include a conductive material, for example, at least one of polycrystalline silicon (Si), titanium (Ti), tantalum (Ta), tungsten (W), ruthenium (Ru), copper (Cu), molybdenum (Mo), platinum (Pt), nickel (Ni), cobalt (Co), aluminum (Al), titanium nitride (TiN), tantalum nitride (TaN), and tungsten nitride (WN).

The contact plug 160cp1 may be connected to an end portion EP of the word line WL. The contact plug 160cp1 may be provided in a connection region IR. The end portion EP of the word line WL may provide an end surface ES exposed in an extension direction of the word line WL, for example, a first direction (X).

The peripheral contact plug 160cp2 may be connected to the peripheral source/drain regions 30 by penetrating the interlayer insulating layers 156 and 158 and the insulating liner 152 in the peripheral circuit region PCR. A peripheral metal-semiconductor compound layer 35 may be disposed between the peripheral contact plug 160cp2 and the peripheral source/drain regions 30. The peripheral contact plug 160cp2 may be connected to the third upper conductive pattern 160p2 and may be integral with the third upper conductive pattern 160p2.

The insulating patterns 165 may be disposed to penetrate the first upper conductive pattern 160c, the second upper conductive pattern 160p1, and the third upper conductive pattern 160p2. The first upper conductive pattern 160c, the second upper conductive pattern 160p1, and the third upper conductive pattern 160p2 may be separated into a plurality of pieces by the insulating patterns 165. The insulating patterns 165 may include an insulating material, for example, at least one of silicon oxide, silicon nitride, and silicon oxynitride.

A peripheral gate structure GS may be disposed on a peripheral active region ACT_P in a peripheral circuit region PCR. The peripheral gate structure GS may include a peripheral gate dielectric layer 40, peripheral gate electrodes 41, 42, and 43, and a peripheral gate capping layer 46 that are sequentially stacked. An insulating liner 152 may cover the peripheral gate structure GS. The peripheral active region ACT_P may be defined by a peripheral device isolation structure 110P, and the peripheral device isolation structure 110P may include a first insulating liner 111 and a second insulating liner 112 that include different materials, but is not limited thereto. The peripheral gate dielectric layer 40 may include silicon oxide, silicon nitride, or a high-κ material. The high-κ material may mean a dielectric material having a higher dielectric constant than silicon oxide. The peripheral gate electrodes 41, 42, and 43 may be formed of a structure and material similar to that of the bit line BL, but may have a shape wider than that of the bit line BL.

According to some implementations, the cell device isolation structure 110C may include a plurality of insulating layers, each of the plurality of insulating layers including a nitride-based silicon insulating material with a different etching selectivity. For example, the first cell device isolation structure 110C1 may include a second insulating layer 116 including a first nitride-based silicon insulating film and a third insulating layer 117 including a second nitride-based silicon insulating film having a different etching selectivity from that of the first nitride-based silicon insulating film. Accordingly, a defect that may be formed in the second insulating layer 116 is not exposed by the third insulating layer 117, and accordingly, a semiconductor device 100 including a word line structure WLS having an ideal profile may be provided.

FIG. 4 is a schematic partially-enlarged view illustrating a semiconductor device 100a according to some implementations.

Referring to FIG. 4, except that the lower surface 117_LS of the third insulating layer 117 has a downward convex shape, the description of FIG. 4 may be the same as or similar to that described with reference to FIGS. 1 to 3.

The lower surface 117_LS of the third insulating layer 117 may have a shape that protrudes downward. For example, the lower surface 117_LS of the third insulating layer 117 may have a convex shape toward the bottom surface of the first trench T_C1.

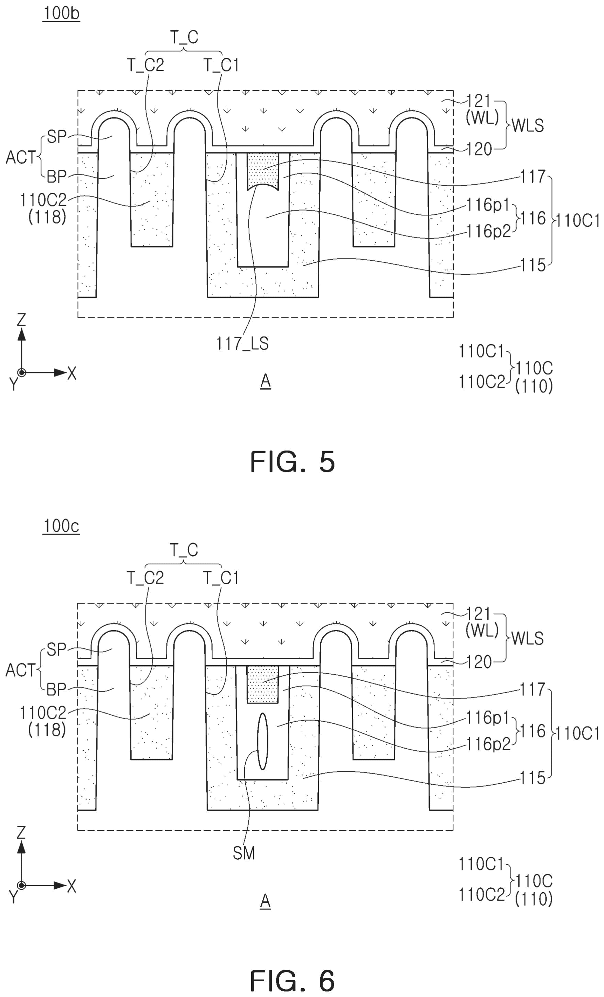

FIG. 5 is a schematic partially-enlarged view illustrating a semiconductor device 100b according to some implementations.

Referring to FIG. 5, except that the lower surface 117_LS of the third insulating layer 117 has a convex shape upward, the description of FIG. 5 may be the same as or similar to that described with reference to FIGS. 1 to 4.

The lower surface 117_LS of the third insulating layer 117 may have a concave shape toward the vertical direction (Z). For example, the lower surface 117_LS of the third insulating layer 117 may have a recessed shape toward the word line structure WLS.

FIG. 6 is a schematic partially-enlarged view illustrating a semiconductor device 100c according to some implementations.

Referring to FIG. 6, except that the second insulating layer 116 includes an air gap SM, the description of FIG. 6 may be the same as or similar to that described with reference to FIGS. 1 to 5.

The second insulating layer 116 may include an air gap SM. For example, the air gap SM may be formed within the second portion 116p2 of the second insulating layer 116. The air gap SM may include a portion whose width in the first direction (X) increases as it goes downward.

The third insulating layer 117 and the air gap SM may be spaced apart in the vertical direction (Z). The width of the third insulating layer 117 in the first direction (X) may be larger than the width of the air gap SM in the first direction (X).

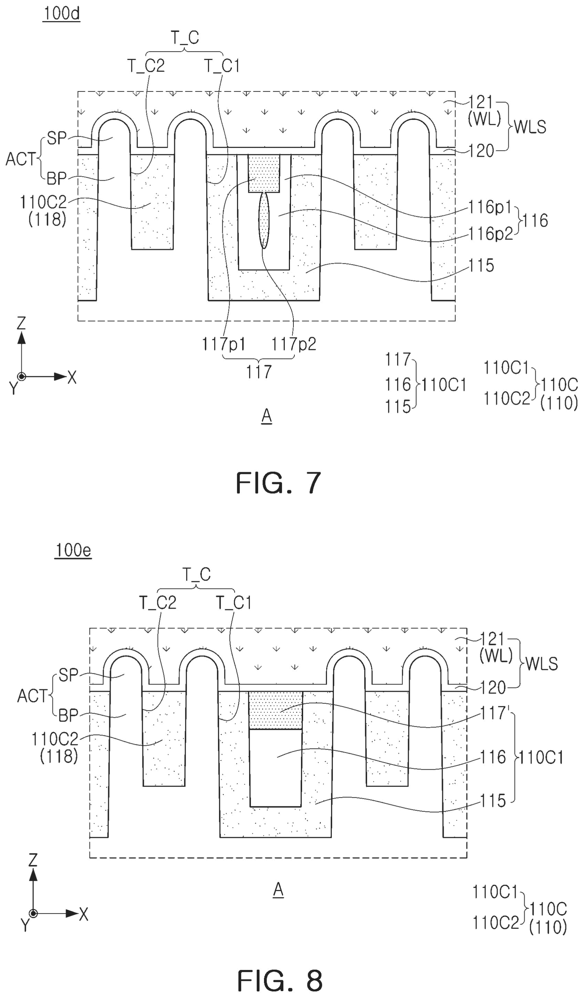

FIG. 7 is a schematic enlarged view illustrating a semiconductor device 100d according to some implementations.

Referring to FIG. 7, the third insulating layer 117 may be identical to or similar to that described with reference to FIGS. 1 to 6, except that it includes a first portion 117p1 disposed in an upper region of the second insulating layer 116 and a second portion 117p2 extending downward from the first portion 117p1.

The first portion 117p1 may have substantially the same characteristics as the third insulating layer 117 described with reference to FIGS. 1 to 3.

The second portion 117p2 may extend downward from the lower surface of the first portion 117p1. The second portion 117p2 may be a structure formed by an insulating material filling an air gap ('SM' of FIG. 6) described with reference to FIG. 6. The second portion 117p2 may include a portion whose width in the first direction (X) increases as it goes downward.

The first and second portions 117p1 and 117p2 may be conveniently described separately to explain the shape of the third insulating layer 117. Accordingly, the boundary between the first and second portions 117p1 and 117p2 may not be distinguished.

FIG. 8 is a schematic partially-enlarged view illustrating a semiconductor device 100e according to some implementations.

Referring to FIG. 8, the third insulating layer 117' may be the same as or similar to that described with reference to FIGS. 1, 2A, 2B, 2C, and 3 to 7, except that it fills the upper region of the second insulating layer 116.

The third insulating layer 117' may completely fill the upper portion of the second insulating layer 116, i.e. the third insulating layer 117' may completely fill an upper portion of the first trench T_C1 across the entire horizontal width of the first trench T_C1. In another aspect, the third insulating layer 117' may cover the upper surface of the second insulating layer 116 and contact the inner side surface of the first insulating layer 115. In this implementation, the upper surface of the first cell device isolation structure 110C1 may be defined as the upper surfaces of the first and third insulating layers 115 and 117'.

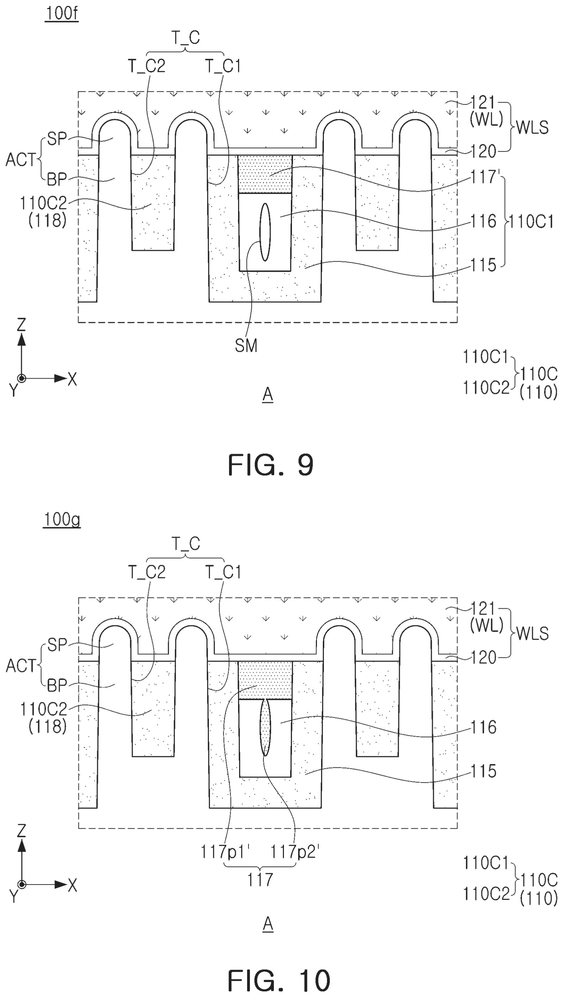

FIG. 9 is a schematic partially-enlarged view illustrating a semiconductor device 100f according to some implementations.

Referring to FIG. 9, the second insulating layer 116 may be the same as or similar to that described with reference to FIGS. 1, 2A, 2B, 2C, and 3 to 8, except that it includes an air gap SM.

The second insulating layer 116 may include an air gap SM. The air gap SM may include a portion whose width in the first direction (X) increases as it goes downward.

The third insulating layer 117' and the air gap SM may be spaced apart in the vertical direction (Z). The width of the third insulating layer 117' in the first direction (X) may be larger than the width of the air gap SM in the first direction (X).

FIG. 10 is a schematic enlarged view illustrating a semiconductor device 100g according to some implementations.

Referring to FIG. 10, the third insulating layer 117' may be identical to or similar to that described with reference to FIGS. 1, 2A, 2B, 2C, and 3 to 9, except that it includes a first portion 117p1' disposed in an upper region of the second insulating layer 116 and a second portion 117p2' extending downward from the first portion 117p1'.

The first portion 117p1' may have substantially the same characteristics as the third insulating layer 117' described with reference to FIG. 8.

The second portion 117p2' may extend downward from the lower surface of the first portion 117p1'. The second portion 117p2' may be a structure formed by an insulating material filling an air gap ('SM' of FIG. 9) described with reference to FIG. 9. The second portion 117p2' may include a portion in which the width in the first direction (X) increases as it goes downward.

The first and second portions 117p1' and 117p2' may be conveniently described separately for explaining the shape of the third insulating layer 117'. Accordingly, the boundary between the first and second portions 117p1' and 117p2' may not be distinguished.

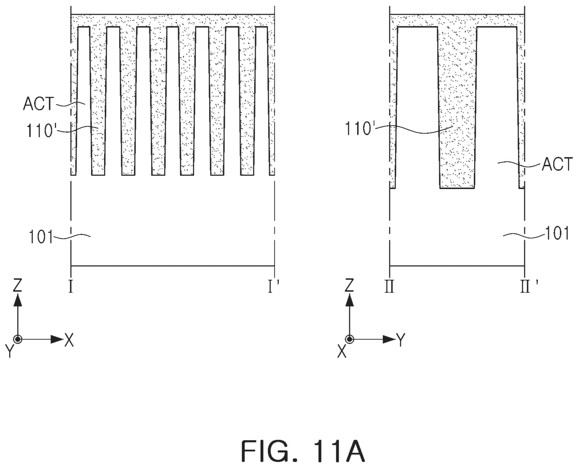

FIGS. 11A, 11B, 12A, 12B, 13A, 13B, 14A, 14B, 15A, 15B, 16A, 16B, 17A, and 17B are cross-sectional views illustrating a process sequence of a method of manufacturing a semiconductor device 100 according to some implementations.

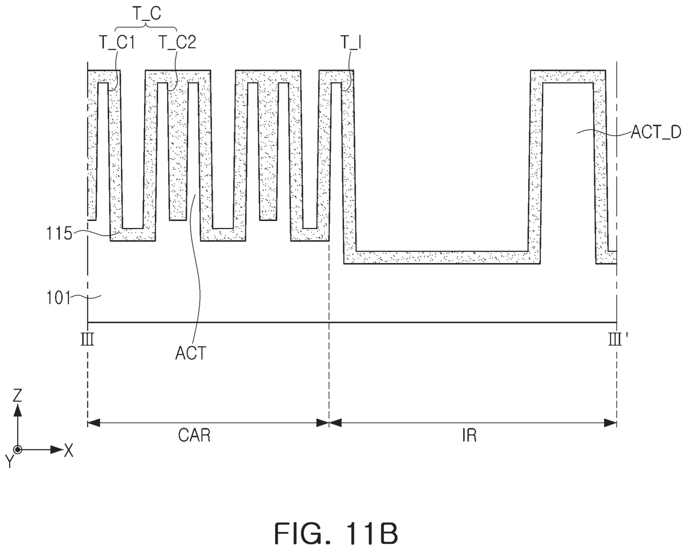

Referring to FIG. 1, FIG. 11A, and FIG. 11B, element isolation trenches T may be formed in a substrate 101, and a first insulating material may be filled within the element isolation trenches T.

The element isolation trenches T may include a cell element isolation trench T_C, a connection element isolation trench T_I, and a peripheral element isolation trench ('T_P' in FIG. 2C).

The cell element isolation trench T_C may be formed to define a cell active region ACT in a cell array region CAR, the connection element isolation trench T_I may be formed to define a dummy active region ACT_D in a connection region IR, and the peripheral element isolation trench ('T_P' in FIG. 2C) may be formed to define a peripheral active region ('ACT_P' in FIG. 2C) in a peripheral circuit region PCR. The cell element isolation trench T_C may include first and second cell element isolation trenches T_C1 and T_C2 that are alternately disposed in the first direction (X). In plan, the cell active region ACT may have a bar shape that is elongated in the W direction.

The insulating material layer formed by the first insulating material may be conveniently referred to as an element isolation insulating layer 110' and a first insulating layer 115. For example, in FIG. 11A, the insulating material layer may be referred to as an element isolation insulating layer 110', and in FIG. 11B, the insulating material layer may be referred to as a first insulating layer 115.

The first insulating layer 115 may be formed in the cell element isolation trench T_C, the connection element isolation trench T_I, and the peripheral element isolation trench ('T_P' in FIG. 2C). The first insulating layer 115 may be, for example, conformally formed on the inner side surface and the bottom surface of the first cell element isolation trench T_C1 and may fill the entirety of the second cell element isolation trench T_C2. In addition, the first insulating layer 115 may be conformally formed on the inner side surface and the bottom surface of the connection element isolation trench T_I. The first insulating material may include silicon oxide.

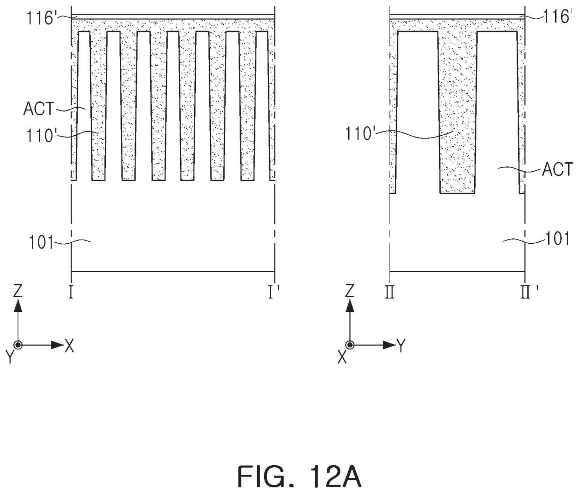

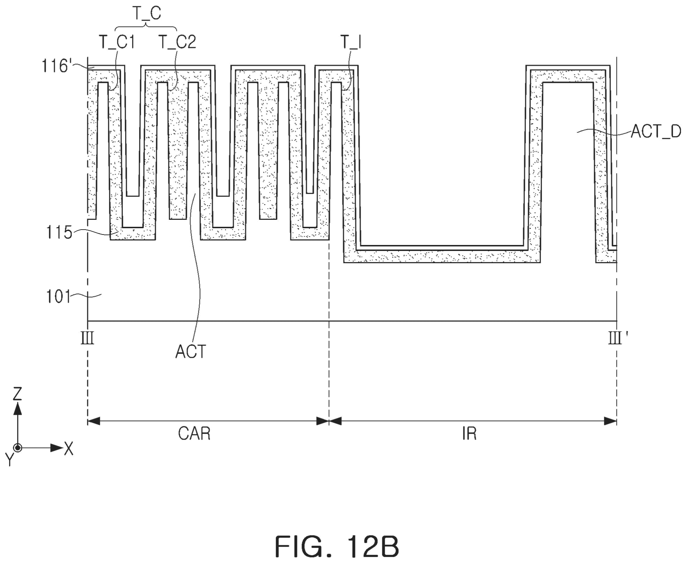

Referring to FIG. 1, FIG. 12A and FIG. 12B, a second preliminary insulating layer 116' may be formed.

The second preliminary insulating layer 116' may be formed by depositing a second insulating material on the element isolation insulating layer 110' and the first insulating layer 115. The second preliminary insulating layer 116' may be formed on the first insulating layer 115 to respectively fill portions of the first cell element isolation trench T_C1 and the connection element isolation trench T_I. The second preliminary insulating layer 116' may be formed with different thicknesses depending on the level within the first cell element isolation trench T_C1. For example, the second preliminary insulating layer 116' may completely fill the lower region of the first cell element isolation trench T_C1 and conformally cover the inner side surface of the upper region of the first cell element isolation trench T_C1. This may be understood as being due to the width of the first cell element isolation trench T_C1 being different along the vertical direction (Z).

The second insulating material may include an insulating material different from the first insulating material. The second insulating material may include, for example, a first nitride-based silicon insulating material.

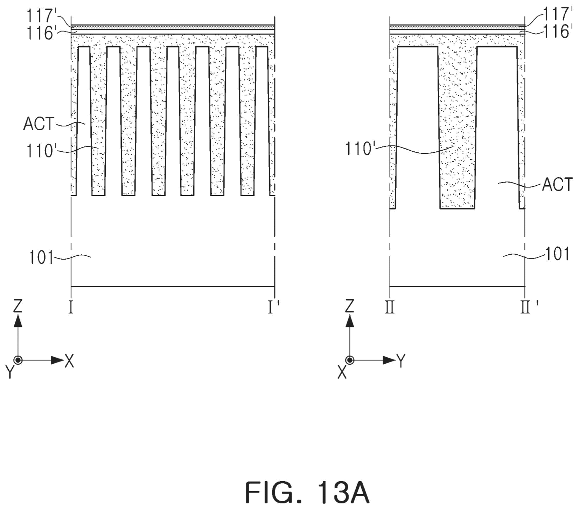

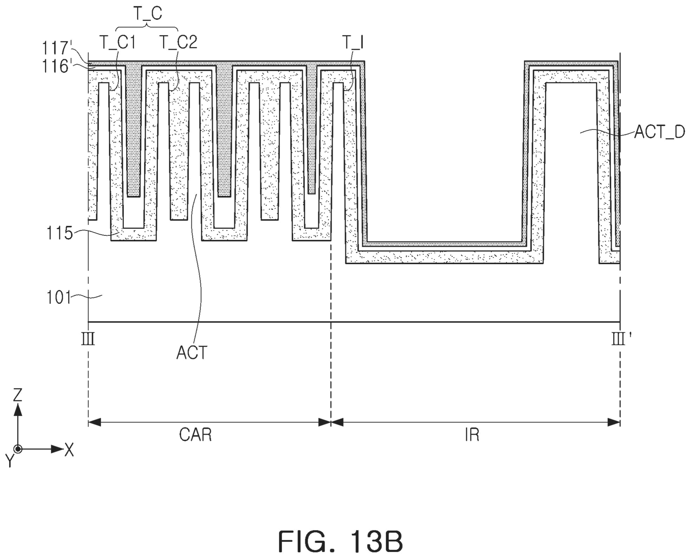

Referring to FIG. 1, FIG. 13A, and FIG. 13B, a third preliminary insulating layer 117' may be formed.

The third preliminary insulating layer 117' may be formed by depositing a third insulating material on the second preliminary insulating layer 116'. The third preliminary insulating layer 117' may be formed on the second preliminary insulating layer 116' to fill the entirety of the first cell element isolation trench T_C1 and a portion of the connection element isolation trench T_I.

The third insulating material may include an insulating material different from the second insulating material. In another aspect, the second and third insulating materials may include materials having a different etching selectivity. The third insulating material may include, for example, a second nitride-based silicon insulating material different from the first nitride-based silicon insulating material.

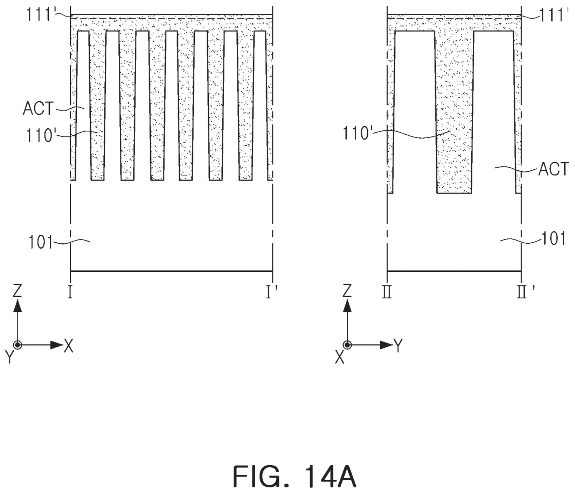

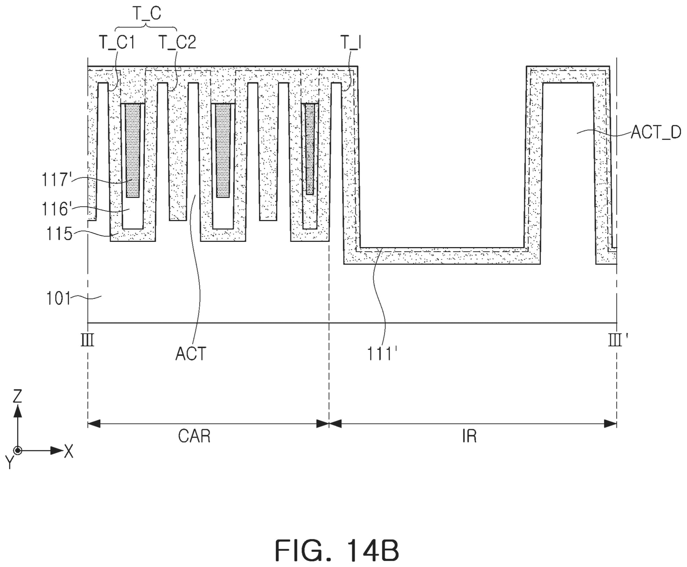

Referring to FIG. 1, FIG. 14A, and FIG. 14B, a portion of the second and third preliminary insulating layers 116' and 117' may be removed, and a first preliminary insulating liner 111' may be formed.

Part of the second and third preliminary insulating layers 116' and 117' may be removed, and only a part filling the first cell element isolation trench T_C1 may remain. Thereafter, a first preliminary insulating liner 111' may be formed. The first preliminary insulating liner 111' may be formed on the element isolation insulating layer 110' (see FIG. 14A) and may be formed on the first insulating layer 115 (see FIG. 14B). The first preliminary insulating liner 111' may include silicon oxide.

The first preliminary insulating liner 111' may not have boundaries with the element isolation insulating layer 110' and the first insulating layer 115, respectively. Accordingly, for convenience, the first preliminary insulating liner 111' disposed on the element isolation insulating layer 110' may be collectively referred to as the element isolation insulating layer 110' hereinafter. In addition, the first insulating layer 115 disposed within the connection element isolation trench T_I may be collectively referred to as the first preliminary insulating liner 111' hereinafter.

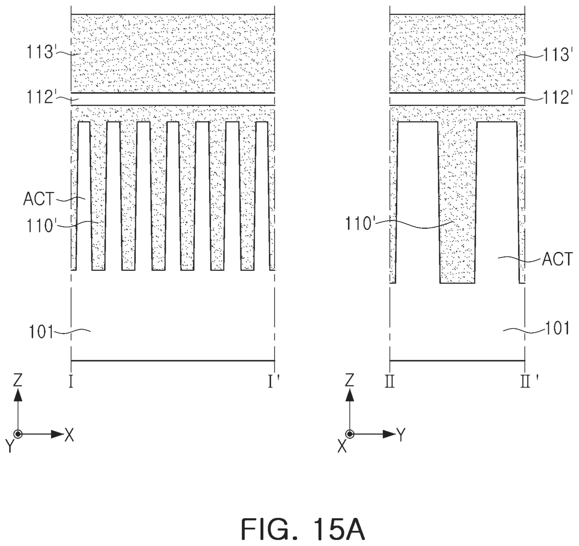

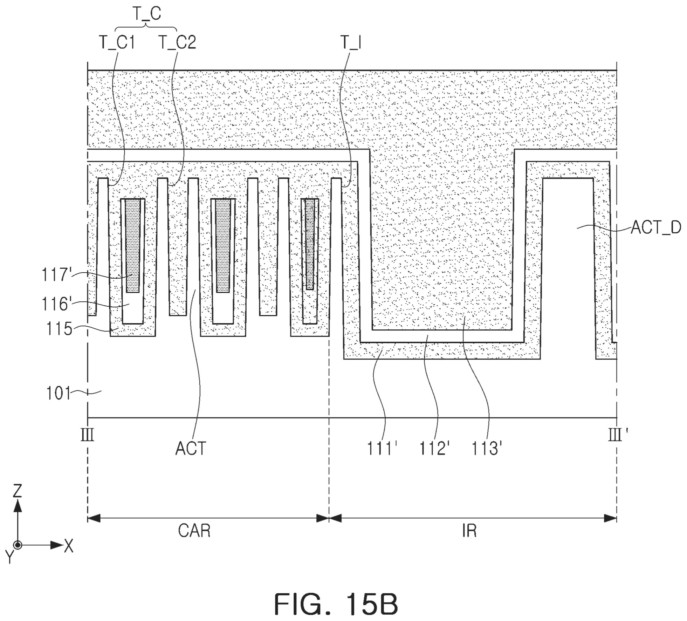

Referring to FIG. 1, FIG. 15A, and FIG. 15B, the second and third preliminary insulating liners 112' and 113' may be formed.

The second and third preliminary insulating liners 112' and 113' may be sequentially formed on the first preliminary insulating liner 111'. The second preliminary insulating liner 112' may include silicon oxide, and the third preliminary insulating liner 113' may include silicon nitride.

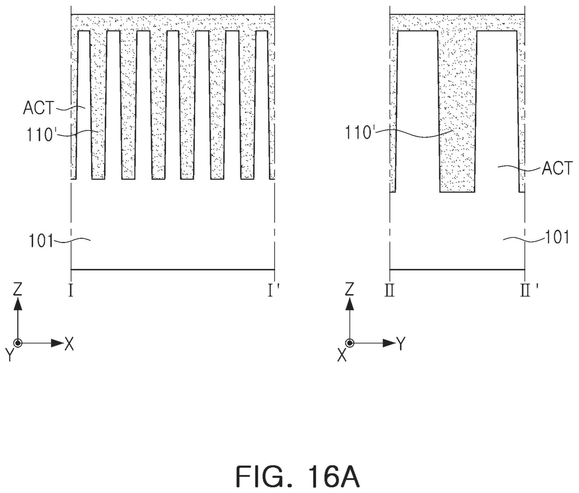

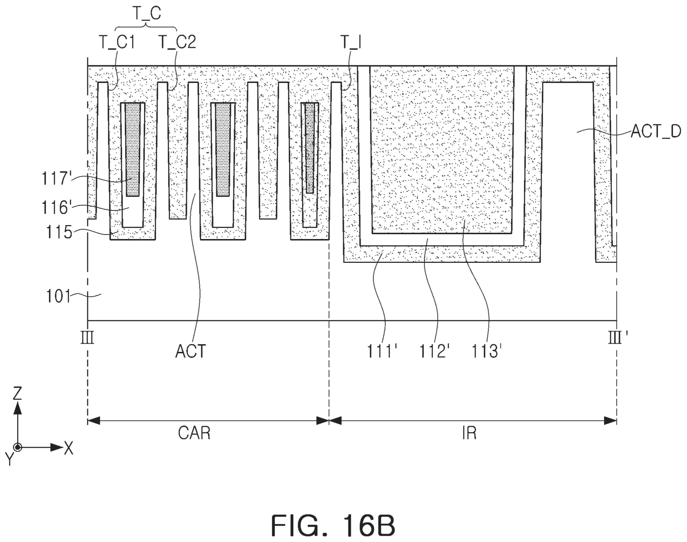

Referring to FIG. 1, FIG. 16A and FIG. 16B, a portion of the second and third preliminary insulating liners 112' and 113' may be removed by the planarization process.

A portion of the second and third preliminary insulating liners 112' and 113' may be removed so that the second preliminary insulating liner 112' remains within the connecting element isolation trench T_I. For example, a horizontal portion of the second preliminary insulating liner 112' may be removed. The portion of the second and third preliminary insulating liners 112' and 113' may be removed by the planarization process.

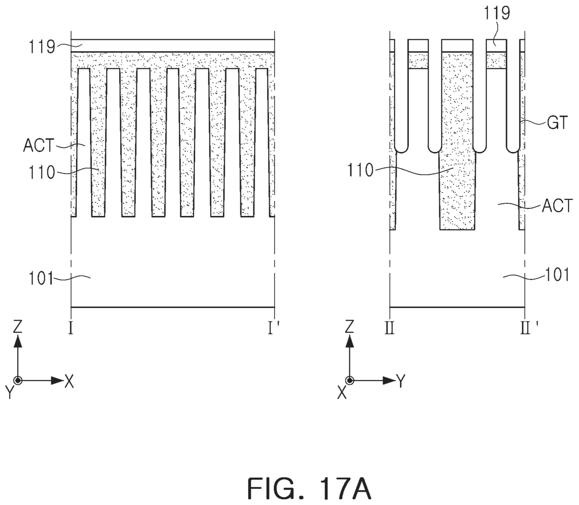

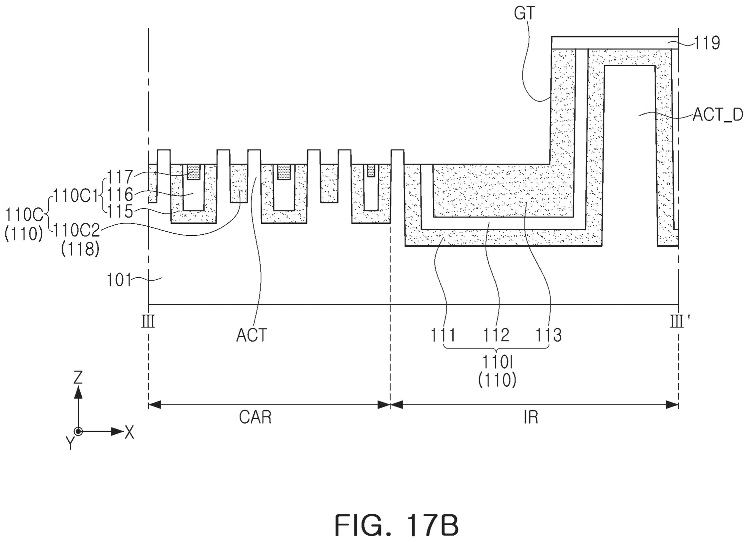

Referring to FIG. 1, FIG. 17A, and FIG. 17B, a mask layer 119 may be formed, and a gate trench GT may be formed using the mask layer 119.

The mask layer 119 may be formed across the cell array region CAR and the connection region IR. Using the mask layer 119, gate trenches GT respectively extending in the first direction (X) and spaced apart from each other in the second direction (Y) may be formed.

A device isolation structure 110 may be defined. For example, cell device isolation structures 110C on the cell array region CAR, a peripheral device isolation structure (110P of FIG. 2C) on the peripheral circuit region (PCR of FIG. 2C), and a connection device isolation structure 110I on the connection region IR may be defined. The cell device isolation structures 110C may include a first cell device isolation structure 110C1 and a second cell device isolation structure 110C2. The second cell device isolation structure 110C2 may be a separation structure defined between two adjacent active regions ACTs.

Within the gate trench GT, an upper region of the active region ACT may be at a higher level than an upper surface of each of the cell device isolation structures 110C. Accordingly, the active region ACT may be defined to include a body portion ('BP' in FIG. 3) and a saddle portion ('SP' in FIG. 3). The saddle portion may be a portion exposed by the gate trench GT.

According to some implementations, by forming a third preliminary insulating layer 117' having an etching selectivity different from that of the second preliminary insulating layer 116' on the second preliminary insulating layer 116', a semiconductor device 100 including a word line structure WLS having a gate electrode (or 'word line WL') having an ideal profile may be provided.

For example, a defect that may be formed in a process of depositing the second preliminary insulating layer 116' (refer to FIG. 12B) may be covered by the third preliminary insulating layer (117' of FIG. 13B). Accordingly, in a process of forming a gate trench (GT of FIG. 17B), the defect may not be exposed due to a different etching selectivity between the second and third insulating layers 116 and 117 (refer to FIG. 17B). In this case, the defect may include an air gap SM described with reference to FIG. 6. Meanwhile, the defect may not be formed.

According to some implementations, a first cell device isolation structure 110C1 having an upper surface substantially coplanar is provided, and accordingly, a semiconductor device 100 including a word line structure WLS having a gate electrode (or 'word line WL') having a lower surface substantially coplanar on the first cell device isolation structure 110C1 may be provided.

Thereafter, referring to FIGS. 2A and 2B together, a gate dielectric layer 120 may be formed on the inner surface of a gate trench GT with a substantially conformal thickness. Subsequently, a lower pattern 121 and an upper pattern 122 may be formed to fill the gate trench GT, and a portion of an upper portion of the upper pattern 122 may be etched to form a word line WL. The upper surface of the word line WL may be recessed to be lower than the upper surface of the active region ACT. An insulating layer may be stacked on the substrate 101 to fill the gate trench GT and etched to form a gate capping layer 125 on the word line WL.

An insulating layer and a conductive layer may be sequentially formed on the entire surface of the substrate 101 and patterned to form a buffer insulating layer 128 and a first conductive pattern 141 that are sequentially stacked. The buffer insulating layer 128 may be formed of at least one of silicon oxide, silicon nitride, and silicon oxynitride. The buffer insulating layer 128 and the first conductive pattern 141 may be used as an etching mask to etch the upper portion of the device isolation region 110, the substrate 101, and the gate capping layer 125 to form a bit line contact hole 135.

A bit line contact pattern DC filling the bit line contact hole 135 may be formed. Forming the bit line contact pattern DC may include forming a conductive layer filling the bit line contact hole 135 and performing a planarization process. For example, the bit line contact pattern DC may be formed of polysilicon. After forming a second conductive pattern 142, a third conductive pattern 143, and first to third capping patterns 146, 147, and 148 in sequence on a first conductive pattern 141, the first to third capping patterns 146, 147, and 148 may be etched in sequence using the first to third capping patterns 146, 147, and 148 as an etching mask. As a result, a bit line structure BLS including a bit line BL including first to third conductive patterns 141, 142, and 143 and a bit line capping pattern BC including first to third capping patterns 146, 147, and 148 may be formed.

A spacer structure SS may be formed on side surfaces of the bit line structure BLS. The spacer structure SS may be formed of a plurality of layers. Fence insulating patterns 154 may be formed between the spacer structures SS. The fence insulating patterns 154 may include silicon nitride or silicon oxynitride.

Peripheral transistors may be formed in a peripheral circuit region PCR. The peripheral transistors may include a peripheral gate structure GS and peripheral source/drain regions 30. A peripheral gate spacer structure SS_P may be formed on a side surface of the peripheral gate structure GS. The peripheral gate structure GS may be formed in the same process step as the formation of the bit line BL, but is not limited thereto. An insulating liner 152, a first interlayer insulating layer 156, and a second interlayer insulating layer 158 covering the peripheral transistors may be formed. Each of the insulating liner 152, the first interlayer insulating layer 156, and the second interlayer insulating layer 158 may include at least one of silicon oxide, silicon nitride, and silicon oxynitride.

A lower conductive pattern 150 and a metal-semiconductor compound layer 155 may be sequentially formed between bit line structures BLS. The lower conductive pattern 150 may be formed of a conductor material such as polysilicon. The formation of the metal-semiconductor compound layer 155 may include a deposition process of a metal layer and a heat treatment process.

A barrier layer 162 and a conductive layer 164 may be sequentially deposited, and a first upper conductive pattern 160c, a contact plug 160cp1, and a peripheral contact plug 160cp2 may be formed. The first upper conductive pattern 160c, the contact plug 160cp1, and the peripheral contact plug 160cp2 may be formed simultaneously. Thereafter, a patterning process may be performed on the barrier layer 162 and the conductive layer 164, to form insulating patterns 165 penetrating therethrough. Thereafter, a capacitor structure including a lower electrode, a capacitor dielectric layer, and an upper electrode may be formed on the first upper conductive pattern 160c.

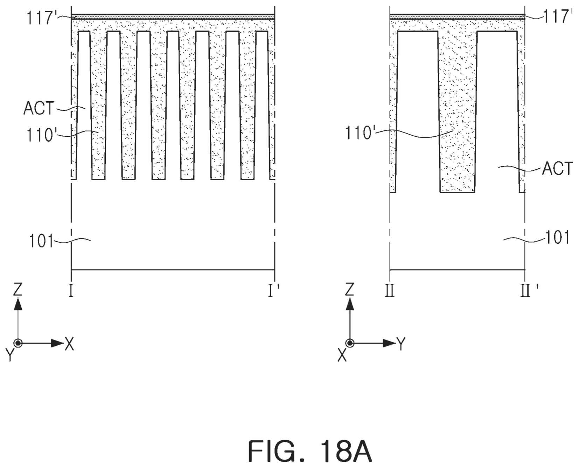

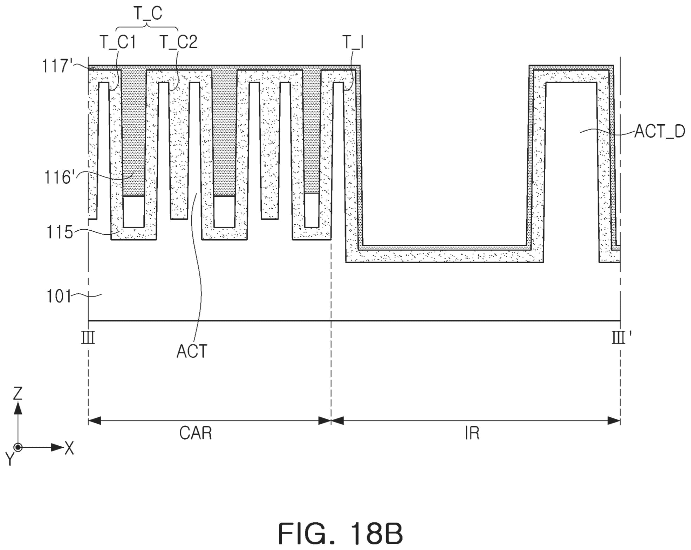

FIGS. 18A and 18B are cross-sectional views illustrating a process sequence of a method of manufacturing a semiconductor device 100e according to some implementations. FIG. 18A is a cross-sectional view illustrating a process continuing from FIG. 12A, and FIG. 18B is a cross-sectional view illustrating a process continuing from FIG. 12B.

Referring to FIGS. 18A and 18B, a portion of the second preliminary insulating liner 116' may be removed, and a third preliminary insulating liner 117' may be formed on the remaining second preliminary insulating liner 116'.

A portion of the second preliminary insulating liner 116' may be removed so that the second preliminary insulating liner 116' remains in the lower region of the first cell element isolation trench T_C1. In another aspect, the second preliminary insulating liner 116' on the inner side surface of the first cell element isolation trench T_C1 and the second preliminary insulating liner 116' within the connection element isolation trench T_I may be removed.

The third preliminary insulating liner 117' may be formed on the remaining second preliminary insulating liner 116'. The third preliminary insulating liner 117' may fill the entirety of the first cell element isolation trench T_C1 and a portion of the connection element isolation trench T_I. Subsequently, a process substantially the same as that described with reference to FIGS. 14A and 14B may be performed.

As set forth above, according to example implementations, a semiconductor device having improved reliability and improved performance and a method of manufacturing the same are provided.

In detail, according to example implementations, a semiconductor device including a cell device isolation structure with a plurality of insulating layers respectively formed of a nitride-based silicon insulating material having a different etching selectivity may be provided.

According to example implementations, a method of manufacturing a semiconductor device includes forming a substrate including a cell array region; forming a plurality of trenches on the substrate, the trenches defining a cell active region on the cell array region and including first and second trenches; forming cell device isolation structures within the plurality of trenches, the cell device isolation structures including a first cell device isolation structure within the first trench and a second cell device isolation structure within the second trench; and forming a gate structure including a gate electrode crossing the cell active region in a first direction, on the cell array region, wherein the first cell device isolation structure includes a first insulating layer on a sidewall and a bottom surface of the first trench; a second insulating layer on the first insulating layer; and a third insulating layer filling at least a portion of an upper region of the second insulating layer, and the second cell device isolation structure includes a buried insulating layer filling the second trench, and a lower surface of the third insulating layer of the first cell device isolation structure is disposed at a higher level than the lower surface of the buried insulating layer of the second cell device isolation structure.

While this disclosure contains many specific implementation details, these should not be construed as limitations on the scope of what may be claimed, equivalents thereof, as well as claims to be described later. Certain features that are described in this disclosure in the context of separate implementations can also be implemented in combination in a single implementation. Conversely, various features that are described in the context of a single implementation can also be implemented in multiple implementations separately or in any suitable subcombination. Moreover, although features may be described above as acting in certain combinations, one or more features from a combination can in some cases be excised from the combination, and the combination may be directed to a subcombination or variation of a subcombination.

While example implementations have been illustrated and described above, it will be apparent to those skilled in the art that modifications and variations could be made without departing from the scope of the present inventive concept as defined by the appended claims.

## Claims

1. A semiconductor device comprising:
a substrate (101) having a cell array region (CAR);
a plurality of trenches defining a cell active region (ACT) on the cell array region (CAR), and including a first trench (T_C1) and a second trench (T_C2);
a first cell device isolation structure (110C1) within the first trench (T_C1);
a second cell device isolation structure (110C2) within the second trench (T_C2), the second cell device isolation structure (110C2) being spaced apart from the first cell device isolation structure (110C1) in a first direction (X); and
a gate structure (WLS) including a gate electrode (WL) crossing the cell active region (ACT) in the first direction (X),
wherein the first cell device isolation structure (110C1) includes:
a first insulating layer (115) on a sidewall and a bottom surface of the first trench (T_C1);
a second insulating layer (116) on the first insulating layer (115); and
a third insulating layer (117) filling at least a portion of an upper region of the second insulating layer,
wherein the second cell device isolation structure (110C2) includes a buried insulating layer (118) in the second trench (T_C2), and
wherein a lower surface of the third insulating layer (117) of the first cell device isolation structure (110C1) is higher than a lower surface of the buried insulating layer (118) of the second cell device isolation structure (110C2).

2. The semiconductor device of claim 1, wherein the gate structure (WLS) includes a gate dielectric layer (120),
wherein the gate dielectric layer (120) is coplanar between the gate electrode (WL) and the first cell device isolation structure (110C1).

3. The semiconductor device of claim 1 or 2, wherein the second insulating layer (116) includes:
a first portion (116p1) between an inner side surface of the first insulating layer (115) and a side surface of the third insulating layer (117), the first portion (116p1) covering the side surface of the third insulating layer (117); and
a second portion (116p2) extending downward from the first portion (116p1) and covering the lower surface of the third insulating layer (117).

4. The semiconductor device of claim 3, wherein a width of the second portion (116p2) in the first direction (X) is greater than a width of the first portion in the first direction (X).

5. The semiconductor device of any one of claims 1 to 4, wherein the lower surface (117_LS) of the third insulating layer (117) has a downwardly convex shape.

6. The semiconductor device of any one of claims 1 to 4, wherein the lower surface (117_LS) of the third insulating layer (117) has an upwardly concave shape.

7. The semiconductor device of any one of claims 1 to 6, wherein the second insulating layer (116) includes an air gap (SM).

8. The semiconductor device of claim 7, wherein the air gap (SM) and the third insulating layer (117) are vertically spaced apart from each other.

9. The semiconductor device of claim 7 or 8, wherein a width of the third insulating layer (117) in the first direction (X) is greater than a width of the air gap (SM) in the first direction (X).

10. The semiconductor device of any one of claims 1 to 6, wherein the third insulating layer (117) includes:
a first portion (117p1) in an upper region of the second insulating layer (116); and
a second portion (117p2) extending downward from the first portion (117p1) and having a width in the first direction (X) smaller than a width of the first portion (117p1) in the first direction (X).

11. The semiconductor device of any one of claims 1 to 10, wherein an upper surface of the first cell device isolation structure (110C1) and an upper surface of the second cell device isolation structure (110C2) are at a same level.

12. The semiconductor device of any one of claims 1 to 11, wherein the first insulating layer (115) and the buried insulating layer (118) include silicon oxide.

13. The semiconductor device of any one of claims 1 to 12, wherein the second insulating layer (116) includes a first nitride-based silicon insulating film, and
wherein the third insulating layer (117) includes a second nitride-based silicon insulating film different from the first nitride-based silicon insulating film.

14. The semiconductor device of any one of claims 1 to 13, wherein the cell active region (ACT) includes:
a body portion (BP) on the substrate (101); and
a saddle portion (SP) protruding from the body portion (BP) toward the gate structure (WLS), and
wherein the second insulating layer (116) and the third insulating layer (117) are spaced apart from the body portion (BP) of the cell active region (ACT).

15. The semiconductor device of claim 14, wherein the body portion (BP) is positioned between the first cell device isolation structure (110C1) and the second cell device isolation structure (110C2).
